# EUROPEAN PATENT APPLICATION

(11) **EP 1 237 276 A2**
(43) Date of publication of application: **04.09.2002**
(21) Application number: 02250242.1
(22) Date of filing: 15.01.2002
(51) Int. Cl.: H03J 5/00, H04N 5/46

(54) **Television tuner**

(30) Priority: 13.02.2001 JP 2001035444
(71) Applicant: ALPS ELECTRIC CO., LTD., Ota-ku Tokyo (JP)
(72) Inventor: Yamamoto, Masaki, c/o Alps Electric Co Ltd, Ota-ku, Tokyo (JP)
(74) Representative: Kensett, John Hinton

(57) **Abstract**

An output capacitance component (Co) of an amplifying element (5a) that constructs a high-frequency amplifier (5) and an inductance element (6) that constructs a parallel-resonant circuit are provided between the high-frequency amplifier and a double-tuned circuit. An inductance value of the inductance element is switched being linked with the band switching of the double-tuned circuit and the parallel-resonant circuit is made to resonate in the vicinity of a minimum frequency in a high-pass frequency band or in the vicinity of a minimum frequency in a low-pass frequency band.

## Description

### BACKGROUND OF THE INVENTION

### 1. Field of the Invention

The present invention relates to a television tuner that receives a television signal from the VHF band to the UHF band.

### 2. Description of the Related Art

Fig. 8 shows the configuration of a conventional television tuner. All television signals from the VHF band to the UHF band are input to a first tuner 32 and a second tuner 33 via an input end 31. The first tuner 32 receives a television signal in all bandwidths of the VHF band and a bandwidth at the low-pass side of the UHF band and the second tuner 33 receives a television signal in a bandwidth at the high-pass side of the UHF band.

An input tuned circuit 34 of the first tuner 32 is provided with a band switching type tuned circuit and switched so as tune to a television signal in a low-pass frequency band from over 40 MHz to 130 or 150 MHz (for example, 140 MHz) or a television signal in a high-pass frequency band from 130 MHz or 150 MHz to 410 MHz or 440 MHz. The television signal selected by this input tuned circuit 34 is input to an input terminal G1 of an amplifying element 35a (field-effect transistor) of a high - frequency amplifier 35.

Voltage is applied from a power supply terminal B to an output terminal D of the amplifying element 35a via a choke inductance element 36.

A double-tuned circuit 37 is provided at the next stage of the high-frequency amplifier 35. The double-tuned circuit 37 is also provided with a band switching type tuned circuit and switched so as tune to a television signal in a low-pass frequency band from over 40 MHz to 130 MHz or 150 MHz (for example, 140 MHz) or a television signal in a high-pass frequency band from 130 MHz or 150 MHz to 410 MHz or 440 MHz.

The double-tuned circuit 37 has a first high-pass tuning inductance element 37a, a first low-pass tuning inductance element 37b, a first varactor diode 37c, and a first switching diode 37d on the primary side and a second high-pass tuning inductance element 37e, a second low-pass tuning inductance element 37f, a second varactor diode 37g, and a second switching diode 37h on the secondary side and is connected as shown in the drawing. Further, the first low-pass tuning inductance element 37b and the second low-pass tuning inductance element 37f are grounded using a coupling inductance element 37i.

Then each anode of the first and second switching diodes 37d, 37h is connected to the connection point between the first high-pass tuning inductance element 37a and the first low-pass tuning inductance element 37b and the connection point between the second high-pass tuning inductance element 37e and the second low-pass tuning inductance element 37f in point of high frequency. Further, each anode is connected to a first switching terminal Hi and each cathode is connected to a second switching terminal Lo. The cathode is grounded using a direct current cut capacitor 37j in point of high frequency and grounded using a resistor 37k.

The double-tuned circuit 37 is connected to a mixer 39 via a coupling varactor diode 38.

Then tuning voltage for varying a tuning frequency is applied to the cathode of the first varactor diode 37c and the cathode of the second varactor diode 37g, but the configuration is not shown.

In the above configuration, when a high-level switching voltage is applied to the first switching terminal Hi, the first and second switching diodes 37d, 37h is turned on. In the double-tuned circuit 37, the connection point between the first high-pass tuning inductance element 37a and the first low-pass tuning inductance element 37b and the connection point between the second high-pass tuning inductance element 37e and the second low-pass tuning inductance element 37f are grounded in point of high frequency. As a result, the double-tuned circuit 37 is tuned to the high-pass frequency band.

Further, when a high-level switching voltage is applied to the second switching terminal Lo, the first and second switching diodes 37d, 37h are turned off and the double-tuned circuit 37 is tuned to the low-pass frequency band.

However, because the ratio of the maximum frequency to the minimum frequency is almost three times as wide as in each frequency band, there has been a problem that a difference is generated in a gain in the band and the gain is decreased at the low-pass side in each low-pass frequency band.

### SUMMARY OF THE INVENTION

Accordingly, an object of the present invention is to almost flatten a gain in each frequency band divided by band switching.

According to an aspect of the present invention, the television tuner has a high-frequency amplifier that amplifies a television signal in all bandwidths of the VHF band and a television signal in a bandwidth at a low-pass side of the UHF band and a band switching type double-tuned circuit that is provided at a next stage of the high-frequency amplifier and of which a tuning frequency is switched to a high-pass frequency band or a low-pass frequency band. An output capacitance component of an amplifying element that constructs the high-frequency amplifier and an inductance element that constructs a parallel-resonant circuit are provided between the high-frequency amplifier and the double-tuned circuit. An inductance value of the inductance element is switched being linked with band switching of the double-tuned circuit. And the parallel-resonant circuit is made to resonate in the vicinity of a minimum frequency in the high-pass frequency band or in the vicinity of a minimum frequency in the low-pass frequency band.

Further, the inductance element has first and second inductance elements connected mutually in series and is provided with a first switching diode that turns on when the double-tuned circuit is switched to the high-pass frequency band and turns off when it is switched to the low-pass frequency band. The first switching diode is provided between a connection point between the first inductance element and the second inductance element, and the ground.

Further, a high-pass tuning inductance element that connects the first inductance element to an output terminal of the amplifying element and connects the second inductance element to the ground, then of which one end is connected to the output terminal of the amplifying element via a first coupling capacitive element, a low-pass tuning inductance element connected in series to the high-pass tuning inductance element, and a second switching diode which is connected between a connection point between the high-pass tuning inductance element and the low-pass tuning inductance element, and the ground, and which turns on when the double-tuned circuit is switched to the high-frequency band and turns off when it is switched to the low-pass frequency band are provided in the double-tuned circuit. The connection point between the first inductance element and the second inductance element and the connection point between the high-pass tuning inductance element and the low-pass tuning inductance element are connected using a second coupling capacitive element and the resonant frequency of a series circuit having the first inductance element and the second coupling capacitive element is made higher than a maximum frequency in the low-pass frequency band.

Further, a resonant frequency of a parallel circuit having the series circuit and the first coupling capacitive element is set within a bandwidth of the high-pass frequency band.

Further, a frequency on which the low-pass frequency band and the high-pass frequency band are split is set to 130 MHz or 150 MHz and a maximum frequency of the high-pass frequency band is set to 410 MHz or 440 MHz.

An embodiment of the present invention will now be described, by way of example only, with reference to the accompanying diagrammatic drawings, in which:

Preferred embodiments of the present invention will be described in detail based on the followings, wherein:
Fig. 1 is a circuit drawing showing the configuration of a first embodiment of a television tuner of the present invention;
Fig. 2 is an equivalent circuit drawing when a high-pass frequency band is received in the television tuner of the present invention;
Fig. 3 is an equivalent circuit drawing when a low-pass frequency band is received in the television tuner of the present invention;
Fig. 4 is a circuit drawing showing the configuration of a second embodiment of the television tuner of the present invention;
Fig. 5 is an equivalent circuit drawing when the low-pass frequency band is received in the second embodiment of the television tuner of the present invention;
Fig. 6 is an equivalent circuit drawing for describing an operation in the second embodiment of the television tuner of the present invention;
Fig. 7 is an equivalent circuit diagram for describing the operation in the second embodiment of the television tuner of the present invention; and
Fig. 8 is a circuit drawing showing the configuration of a conventional television tuner.

### DESCRIPTION OF PREFERRED EMBODIMENTS

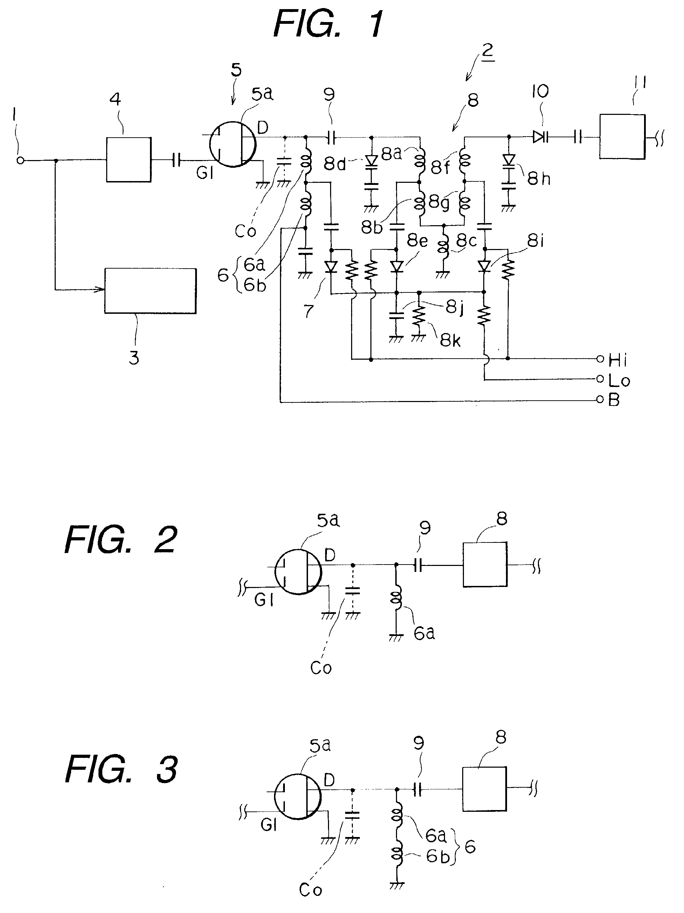

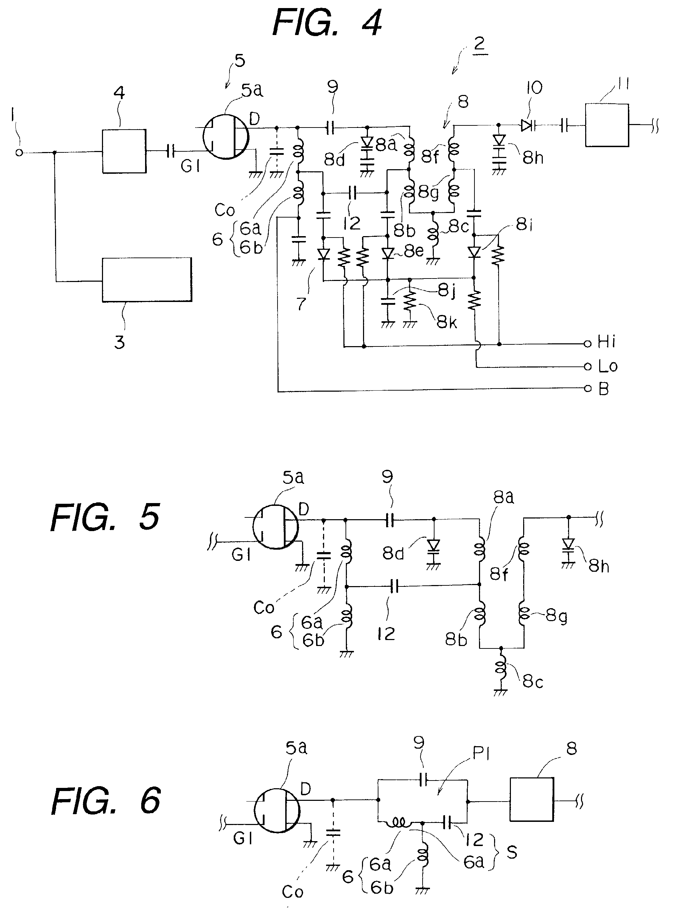

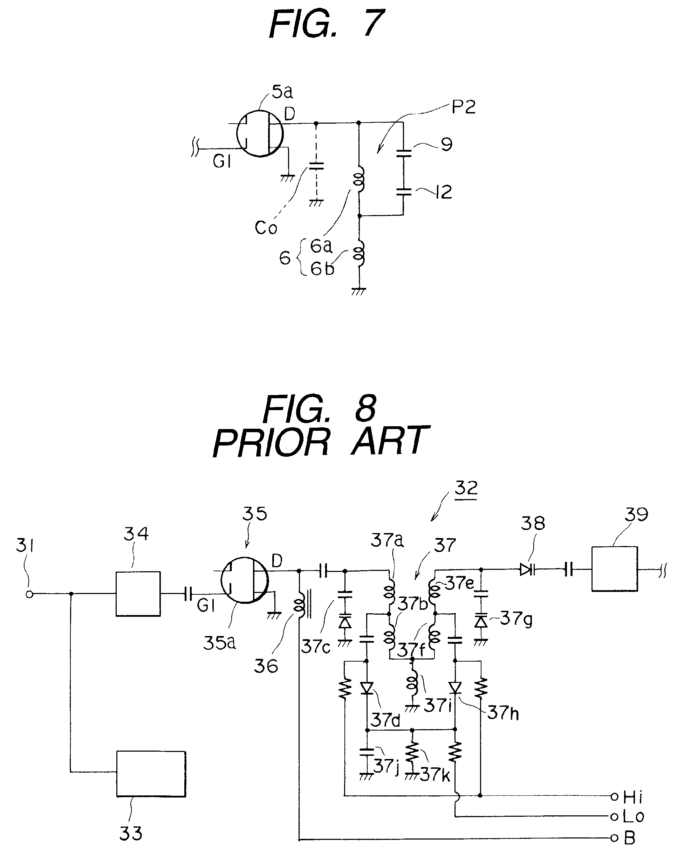

A television tuner of the present invention is described below with reference to the drawings. Here, Fig. 1 shows the configuration of a first embodiment and Fig. 2 shows an equivalent circuit when a television signal in a high-pass frequency band is received, Fig. 3 shows an equivalent circuit when a television signal in a low-pass frequency band is received, Fig. 4 shows the configuration of a second embodiment, Fig. 5 shows an equivalent circuit of the second embodiment, and Figs. 6 and 7 show equivalent circuits for describing an operation when the television signal in the low-pass frequency band is received.

First, in Fig. 1, all television signals from the VHF band to the UHF band are input to a first tuner 2 and a second tuner 3 via an input end 1. The first tuner 2 receives a television signal in all bandwidths of the VHF band and a bandwidth at the low-pass side of the UHF band and the second tuner 3 receives a television signal in a bandwidth at the high-pass side of the UHF band. As an example, in the cable television specifications in Europe, a television signal from over 40 MHz to 410 MHz or 440 MHz (for example, 423 MHz) is received by the first tuner 2 and a television signal of a higher frequency than it is received by the second tuner 3. Further, the first tuner 2 divides a television signal in the frequency band at 410 MHz or less than 440 MHz into two bandwidths and receives it.

An input tuned circuit 4 of the first tuner 2 has a band switching type tuned circuit and is switched so as tune to a television signal in a low-pass frequency band from over 40 MHz to 130 or 150 MHz (for example, 140 MHz) or a television signal in a high-pass frequency band from 130 MHz or 150 MHz to 410 MHz or 440 MHz. The television signal selected by this input tuned circuit 4 is input to an input terminal G1 of an amplifying element 5a (field-effect transistor) of a high-frequency amplifier 5.

The amplifying element 5a has an internal capacitance component (referred to as an output capacitance component) Co (the capacitance value is about 10 pF (picofarad)) at the side of an output terminal D and this Co is connected equivalently between the output terminal D and the ground. Power supply voltage is applied to the output terminal D via an inductance element 6, but the inductance element 6 is connected in parallel to the output capacitance component Co in point of high frequency. The inductance element 6 has a first inductance element 6a and a second inductance element 6b that are mutually connected in series. The inductance value of the first inductance element 6a is about one tenth the inductance value of the second inductance element 6b.

Then the first inductance element 6a is connected to the output terminal D of the amplifying element 5a and the second inductance element 6b is connected to a power supply source B. Further, an anode of the first switching diode 7 is connected in point of high frequency to the connection point between the first inductance element 6a and the second inductance element 6b. The anode is connected to a first switching terminal Hi and the cathode is connected to a second switching terminal Lo.

A double-tune circuit 8 is provided in the next stage of the high-frequency amplifier 5. The double-tuned circuit 8 also has a band switching type tuned circuit and switched so as tune to a television signal in a low-pass frequency band from over 40 MHz to 130 or 150 MHz (for example, 140 MHz) or a television signal in a high-pass frequency band from 130 MHz or 150 MHz to 410 MHz or 440 MHz.

Then a first high-pass tuning inductance element 8a at the primary side of the double-tuned circuit 8 is connected to the output terminal D of the amplifying element 5a via a first coupling capacitive element 9.

A first low-pass tuning inductance element 8b and a coupling inductance element 8c are sequentially connected in series to the first high-pass tuning inductance element 8a and the coupling inductance element 8c is grounded. An anode of a first varactor diode 8d is connected to the connection point between the first coupling capacitive element 9 and the first high-pass tuning inductance element 8a, and the cathode is grounded in point of high frequency. The tuning voltage for varying a tuning frequency is applied to a cathode of the first varactor diode 8d, but the configuration is not shown. Further, an anode of a second switching diode 8e is connected to the connection point between the first high-pass tuning inductance element 8a and the first low-pass tuning inductance element 8b in point of high frequency. The anode is connected to the first switching terminal Hi and the cathode is connected to the second switching terminal Lo.

A second high-pass tuning inductance element 8f and a second low-pass tuning inductance element 8g that correspond to the first high-pass tuning inductance element 8a and the first low-pass tuning inductance element 8b at the primary side respectively are provided at the secondary side of the double-tuned circuit 8. The second high-pass tuning inductance element 8f and the second low-pass tuning inductance element 8g are mutually connected in series and connected to the coupling inductance element 8c. Further, the second high-pass tuning inductance element 8f is coupled with a mixer 11 via a coupling varactor diode 10. Further, an anode of a second varactor diode 8h is connected to the connection point between the second high-pass tuning inductance element 8f and the coupling varactor diode 10 and the cathode is grounded in point of high frequency. Tuning voltage is applied to the cathode of the second varactor diode 8h. Further, an anode of a third switching diode 8i is connected to the connection point between the second high-pass tuning inductance element 8f and the second low-pass tuning inductance element 8g in point of high frequency. The anode is connected to the first switching terminal Hi and the cathode is connected to the second switching terminal Lo.

The tuning frequencies caused by the above three inductance elements 8a, 8b, 8c connected in series at the primary side and the first varactor diode 8d and the tuning frequencies caused by the three inductance elements 8f, 8g, 8c and the second varactor diode 8h connected in series at the secondary side are identical mutually and change in the low-pass frequency band.

Then the cathodes of the first to third switching diodes 7, 8e, 8i are grounded in point of high frequency using a direct current cut capacitor 8j and grounded in point of direct current using a resistor 8k.

In the above configuration, when a high-level switching voltage is applied to the first switching terminal Hi, the first to third switching diodes 7, 8e, 8i is turned on. In the double-tuned circuit 8, the connection point between the first high-pass tuning inductance element 8a and the first low-pass tuning inductance element 8b and the connection point between the second high-pass tuning inductance element 8f and the second low-pass tuning inductance element 8g are grounded in point of high frequency. As a result, the double-tuned circuit 8 is tuned to the high-pass frequency band.

In this case, the connection point between the first inductance element 6a and the second inductance element 6b is also grounded in point of high frequency. The equivalent circuit is shown in Fig. 2. A parallel-resonant circuit is formed using the output capacitance component Co of the amplifying element 5a and the first inductance element 6a and the resonant frequency is set to the vicinity (about 140 MHz) of the minimum frequency in a high-pass frequency band. Accordingly, a decrease in the gain of the high-frequency amplifier 5 at the low-pass side in the high-pass frequency band is improved.

Further, when a high-level switching voltage is applied to the second switching terminal Lo, the first to third switching diodes 7, 8e, 8i are turned off and the double-tuned circuit 8 is tuned to the low-frequency band.

In this case, when the entirety of the inductance 6 having the first inductance element 6a and the second inductance element 6b is connected in parallel to the output capacitance component Co, a parallel-resonant circuit is formed and the equivalent circuit is shown in Fig. 3. Then a resonant frequency reaches the vicinity (between 40 MHz and 50 MHz) of the minimum frequency in a low-pass frequency band. Accordingly, a decrease in the gain of the high-frequency amplifier 5 at the low-pass side in the low-pass frequency band is improved.

As described above, because the decrease of the gain at the low-pass side of each frequency band can be improved, the gain in each frequency band can be flattened. As described in this embodiment in particular, if the frequency on which a low-pass frequency band and a high-pass frequency band are split is set to 130 MHz or 150 MHz and the maximum frequency in the high-pass frequency band is set to 410 MHz or 440 MHz so that the ratio of the maximum frequency to the minimum frequency in each frequency band can be set to almost 3:1, a flat gain is obtained from low frequency to high frequency. A television tuner that is suitable for the use in Europe in particular is obtained.

Fig. 4 shows that the connection point between the first inductance element 6a and the second inductance element 6b and the connection point between the first high-pass tuning inductance element 8a and the first low-pass tuning inductance element 8b in Fig. 1 are connected using a second coupling capacitive element 12 and the rest is identical with the configuration of Fig. 1. Also in this second embodiment, when a high-level switching voltage is applied to the first switching terminal Hi and the double-tuned circuit 8 is switched so as to tune to a high-pass frequency band, the equivalent circuit shown in Fig. 2 is formed.

On the other hand, when a high-level switching voltage is applied to the second switching terminal Lo and the double-tuned circuit 8 is switch so as to tune to a low-pass frequency band, the equivalent circuit shown in Fig. 5 is obtained. Further, because the inductance value of the first high-pass tuning inductance element 8a is exceedingly lower than the inductance value of the first low-pass tuning inductance element 8b, Fig. 5 is further shown in Fig. 6 or 7 if this inductance value is ignored.

Here, referring to Fig. 6, a series circuit S having the first inductance element 6a and the second coupling capacitive element 12 and a parallel circuit P1 having the series circuit S and the first coupling capacitive element 9 intervene between the amplifying element 5a and the double-tuned circuit 8. Further, when a resonant frequency F1 of the series circuit S is set above the maximum frequency in a low-pass frequency band, the series circuit S becomes capacitive. The coupling between the amplifier 5 and the double-tuned circuit 8 increases and the total gain increases.

Moreover, because a parallel-resonant frequency F2 of the parallel circuit P1 becomes higher than the series resonant frequency F1, a parallel circuit P2 forms a trap circuit that attenuates a high-pass frequency band if the former frequency is set within a bandwidth of the high-pass frequency band. Therefore, selectivity when a television signal in a low-pass frequency band, in the vicinity of the upper limit in particular, is improved and jamming can be made unlikely to be caused.

Further, as shown in Fig. 7, the parallel circuit P2 is formed using the first coupling capacitive element 9, the second coupling capacitive element 12, and the first inductance element 6a. However, because the resonant frequency of this parallel circuit P2 is set to F2, the parallel circuit P2 becomes inductive in a low-pass frequency band. Moreover, because the equivalent inductance value becomes higher than the inductance value of the first inductance element 6a, the inductance value of the second inductance element 6a can be reduced as much. Therefore, the second inductance element 6b can be provided with a compact air-core coil.

Further, referring to Fig. 7, the resonant frequency ω2 becomes higher than the resonant frequency ω1 in the parallel-resonant circuit P2 having the first inductance element 6a, the second coupling capacitive element 12, and the first coupling capacitive element 9 that are connected in series. Accordingly, if this resonant frequency ω2 is set within a bandwidth of a high-pass frequency band, the parallel-resonant circuit P2 forms a trap circuit that attenuates a high-pass frequency band. Therefore, the selectivity when a television signal in the vicinity of the upper limit, in a low-pass frequency band in particular, is improved and jamming can be made unlikely to be caused.

Many advantages are obtained by connecting the connection point between the first inductance element 6a and the second inductance element 6b and the connection point between the first high-pass tuning inductance element 8a and the first low-pass tuning inductance element 8b using the second coupling capacitive element 12.

As described above, an output capacitance component of an amplifying element that constructs a high-frequency amplifier and an inductance element that constructs a parallel-resonant circuit are provided between the high-frequency amplifier and a double-tuned circuit and an inductance value of the inductance element is switched being linked with the band switching of the double-tuned circuit. At the same time, the parallel-resonant circuit is made to resonate in the vicinity of the maximum frequency in a high-pass frequency band or in the vicinity of the minimum frequency in a low-pass frequency band. Accordingly, a decrease in a gain at the low-pass side of each frequency band can be improved and the gain in each frequency band can be flattened.

Further, because an inductance element has first and second inductance elements mutually connected in series and a first switching diode that is turned on when a double-tuned circuit is switched to a high-pass frequency band and turned off when it is switched to a low-pass frequency band, then the first switching diode is provided between the connection point between the first inductance element and the second inductance element, and the ground, an inductance value is switched in accordance with the switching of the frequency band.

Further, a first inductance element is connected to an output terminal of an amplifying element and a second inductance element is connected to the ground. A high-pass tuning inductance element of which one end is connected to the output terminal of the amplifying element via a first coupling capacitive element and a low-pass tuning inductance element connected in series to the high-pass tuning inductance element are provided in a double-tuned circuit via the first coupling capacitive element. The connection point between the first inductance element and the second inductance element and the connection point between the high-pass tuning inductance element and the low-pass tuning inductance element are connected using a second coupling capacitive element. The resonant frequency of a series circuit having the first inductance element and the second coupling capacitive element is made higher than the maximum frequency in a low-pass frequency band. Accordingly, when the double-tuned circuit is switched to the low-pass frequency band, the coupling between an amplifier and the double-tuned circuit is strengthened and a gain is increased. Further, because a parallel circuit having the first inductance element and the first and second coupling capacitive elements become inductive, the inductance value of the second inductance element can be reduced and the second inductance element can be provided with an air-cone coil.

Further, because the resonant frequencies of the series circuit having the first inductance element and the second coupling capacitive element and the parallel circuit having the first coupling capacitive element are set within a bandwidth in a high-pass frequency band, a trap circuit that attenuates the high-pass frequency band is constructed. The selectivity when a television signal in a low-pass frequency band, in the vicinity of the upper limit in particular, is improved and jamming ca be made unlikely to be caused.

Further, the frequency on which a low-pass frequency band and a high-pass frequency band are split is set to 130 MHz or 150 MHz and the maximum frequency in a high-pass frequency band is set to 410 MHz or 440 MHz. Accordingly, a flat gain is obtained from low frequency to high frequency and a television tuner suitable for the use in Europe can be constructed.

## Claims

1. A television tuner, comprising:
a high-frequency amplifier that amplifies a television signal in all bandwidths of the VHF band and a television signal in a bandwidth at a low-pass side of the UHF band and a band switching type double-tuned circuit that is provided in a next stage of the high-frequency amplifier and of which a tuning frequency is switched to a high-pass frequency band or a low-pass frequency band,
wherein an output capacity component of an amplifying element that constructs the high-frequency amplifier and an inductance element that constructs a parallel-resonant circuit are provided between the high-frequency amplifier and the double-tuned circuit, wherein an inductance value of the inductance element is switched being linked with band switching of the double-tuned circuit, and wherein the parallel-resonant circuit is made to resonate in the vicinity of a minimum frequency in the high-pass frequency band or in the vicinity of a minimum frequency in the low-pass frequency band.

2. The television tuner according to claim 1, wherein the inductance element comprises first and second inductance elements mutually connected in series, wherein a first switching diode that turns on when the double-tuned circuit is switched to the high-pass frequency band and turns off when it is switched to the low-pass frequency band is provided, and wherein the first switching diode is provided between a connection point between the first inductance element and the second inductance element, and the ground.

3. The television tuner according to claim 2, further comprising a high-pass tuning inductance element that connects the first inductance element to an output terminal of the amplifying element and connects the second inductance element to the ground, then of which one end is connected to the output terminal of the amplifying element via a first coupling capacitive element in the double-tuned circuit, a low-pass tuning inductance element connected in series to the high-pass tuning inductance element, and a second switching diode which is connected between a connection point between the high-pass tuning inductance element and the low-pass tuning inductance element, and the ground and which turns on when the double-tuned circuit is switched to the high-pass frequency band and turns off when it is switched to the low-pass frequency band, wherein the connection point between the first inductance element and the second inductance element and the connection point between the high-pass tuning inductance element and the low-pass tuning inductance element are connected using a second coupling capacitive element, and wherein a resonant frequency of a series circuit consisting of the first inductance element and the second coupling capacitive element is made higher than maximum frequency in the low-pass frequency band.

4. The television tuner according to claim 3, wherein a resonant frequency of a parallel circuit consisting of the series circuit and the first coupling capacitive element is set within a bandwidth of the high-pass frequency band.

5. The television tuner according to any one of claims 1 to 4, wherein a frequency on which the low-pass frequency band and the high-pass frequency band are split is set to 130 MHz to 150 MHz and a maximum frequency of the high-pass frequency band is set to 410 MHz to 440 MHz.
